# EUROPEAN PATENT APPLICATION

(11) **EP 1 662 571 A2**
(43) Date of publication of application: **31.05.2006**
(21) Application number: 05023499.6
(22) Date of filing: 27.10.2005
(51) Int. Cl.: H01L 27/32, H01L 51/56

(54) **Active matrix substrate, electro-optical device, electronic apparatus, and manufacturing method of active matrix substrate**

(30) Priority: 29.11.2004 JP 2004343422
(71) Applicant: SEIKO EPSON CORPORATION, Shinjuku-ku, Tokyo 163-0811 (JP)
(72) Inventor: Kawase, Takeo, Suwa-shi, Nagano-ken 392-8502 (JP)
(74) Representative: HOFFMANN EITLE

(57) **Abstract**

An active matrix substrate, comprises: a plurality of first wiring on a base; a plurality of second wiring intersecting a plurality of the first wiring; an insulating film insulating the first wiring and the second wiring; a plurality of pixel electrodes adjacent to the second wiring; and a semiconductor film formed corresponding to each of the plurality of the pixel electrodes. The semiconductor film overlays at least one intersection of a plurality of intersections, in which the plurality of the first wiring intersect the plurality of the second wiring, and one of the plurality of the pixel electrodes.

## Description

### BACKGROUND OF THE INVENTION

### 1. Technical Field

The invention relates to an active matrix substrate having a transistor, an electro-optical device, an electronic apparatus, and a manufacturing method of an active matrix substrate.

### 2. Related Art

In recent years, improvement of alignment accuracy to provide finer precision to electro-optical devices and the like has been an important technological task. Especially in a flexible display using a flexible substrate for a substrate, this has become one of the critical tasks to be solved. In regard to literature concerning the flexible display, for example, Japanese Unexamined Patent Publication No. Hei5-55568, W00147045 and W00147043 are cited as examples of related art.

In Japanese Unexamined Patent Publication No. H5-55568, there is disclosed formation of a gate electrode, a source electrode, and a drain electrode using vacuum evaporation. In this way, it is possible to manufacture a high-performance transistor with good reproducibility by forming the gate electrode, the source electrode, and the drain electrode as well as an insulating film and a semiconductor film through vacuum evaporation.

On the other hand, in WO0147045 and W00147043, there are disclosed film formation of all films of the gate electrode, the source electrode, the drain electrode, the insulating film, and the organic semiconductor film using a wet process under atmospheric pressure.
By this means, it is possible to manufacture a transistor at low cost. When such transistor is used for switching the pixel electrodes, a highly fine display is possible. Further, if an element is formed on a base material composed of a flexible material such as plastics by utilizing an advantage that enables electrodes and semiconductor films to be made at low temperature, flexible display elements can be realized.

### SUMMARY

An advantage of the invention is to provide an active matrix substrate, an electro-optical device, an electronic apparatus, and a manufacturing method of an active matrix substrate.

According to a first aspect of the invention, an active matrix substrate includes: a plurality of first wirings (first lines) on a base material, a plurality of second wirings (second lines) intersecting the plurality of the first wiring, an insulating film insulating the first wiring and the second wiring, and a plurality of pixel electrodes adjacent to the second wiring, wherein a semiconductor film corresponding to each of the plurality of the pixel electrodes is set up, and the semiconductor film overlays at least one intersection of a plurality of intersections in which the plurality of the first wiring intersect the plurality of the second wiring, and one of the plurality of the pixel electrodes.
This enables a transistor having part of the semiconductor film as a channel region to be formed, with the first wiring as a gate electrode , the second wiring as a source electrode and the pixel electrode as a drain electrode.

At this point, the first wiring is, for example, a scanning line of the active matrix substrate and the second wiring corresponds to a data line when the first wiring is a scanning line.

The plurality of the pixel electrodes of the above-referenced active matrix substrate are formed in any of a first layer in which the plurality of the first wiring are formed, a second layer in which the plurality of the second wiring are formed, and a third layer which is positioned between the first layer and the second layer. Further, the semiconductor film covers at least part of one of the plurality of the second wiring.

Further, the above-referenced active matrix substrate may be such that of the plurality of the pixel electrodes, two pixel electrodes adjacent to each other by way of one of the plurality of the second wiring may overlay at least part of the second wiring. This enables a space between the pixel electrode and the second wiring to be made narrower than a forming area of the semiconductor film, thus increasing the rate of opening.

Further, the above-referenced substrate is such that an area overlaying the first wiring of the plurality of the pixel electrodes undergoes a change. Or a ratio of area which is obtained by dividing the area by the first wiring of the plurality of the pixel electrodes undergoes a change.

Further, the above-referenced active matrix substrate is such that the semiconductor film may be an island film that is formed in a form of an isolated island.

Further, the above-referenced active matrix substrate is such that an area overlaying the first wiring of the plurality of the pixel electrodes undergoes variation. A ratio of area divided by the first wiring of the plurality of the pixel electrodes undergoes variation.
Further, the above-referenced active matrix substrate is such that the second wiring and the pixel electrode may be formed of the same material.

Further, the above-referenced active matrix substrate is such that the base material may be of a flexible material.

Further, an electro-optical device of the invention provides an electro-optical material on the pixel electrode of the above-referenced active matrix substrate.

An electro-optical material herein is, for example, a general nomenclature for a liquid crystal device, an electrophoretic element having a dispersed medium in which electrophoretic particles are dispersed, an EL element and the like. The electro-optical device refers to a device having these electro-optical materials on the above-referenced active matrix substrate.

Further, an electronic apparatus of the invention includes the above-referenced electro-optical device.

The electronic apparatus herein refers to general equipment having a fixed function with provision of the active matrix substrate according to the invention and, for example, is constituted by an electro-optical device and a memory.
While its configuration is not particularly specified, for example, there are included an IC card, a mobile phone, a video camera, a personal computer, a head mount display, a rear type or a front type projector, and further, a fax machine with a display function, a digital camera finder, a portable TV, a DSP, a PDA, an electronic notebook, an electric bulletin board, a display for advertising, and the like.

Further, a manufacturing method of an active matrix substrate of the invention includes a process of forming first wiring on the base material, a process of forming an insulating film on the first wiring, a process of forming second wiring and a pixel electrode on the insulating film such that they respectively intersect the first wiring, and a process of forming a semiconductor film on the second wiring and the pixel electrode such as to overlay a first intersection, in which the first wiring and the second wiring intersect, and a second intersection in which the pixel electrode and the second wiring intersect. By this means, in forming the second wiring and the pixel electrode, even if an overlaying position of the first wiring and the pixel electrode varies with each pixel electrode, it is possible to obtain a transistor.

Further, the manufacturing method of the above-referenced active matrix substrate is such that the semiconductor film is formed through drying a liquid material coated by an inkjet process. This makes it possible to consume less amount of the semiconductor material.

Further, the manufacturing method of the above-referenced active matrix substrate is such that the semiconductor film is formed by patterning while leaving a photoresist area coated by the inkjet process.

Further, the manufacturing method of the above-referenced active matrix substrate includes a process of detecting an alignment mark formed on the base material, and a process of controlling a relative position of an inkjet head, which is used for the inkjet process according to a detected value obtained by the detection, and the base material. This alignment mark may be the first intersection or the second intersection.

### BRIEF DESCRIPTION OF THE DRAWINGS

The invention will be described with reference to the accompanying drawings, wherein like numbers refer to like elements, and wherein;
Fig. 1 is a diagram showing an active matrix substrate of the invention, Fig. 1A is a plan view, and Fig. 1B is a longitudinal sectional view;
Fig. 2 is a diagram (plan view) to explain a manufacturing method of an active matrix substrate shown in Fig. 1;
Fig. 3 is a diagram (plan view) to explain a manufacturing method of an active matrix substrate shown in Fig. 1;
Fig. 4 is a diagram (plan view) showing an active matrix of the invention; and
Fig. 5 presents a diagram showing examples of various electronic equipment constituted by including electro-optical devices.

### DESCRIPTION OF THE EMBODIMENTS

The invention will now be described in detail.

### First Embodiment

In the embodiment, an active matrix substrate of the invention will be described.

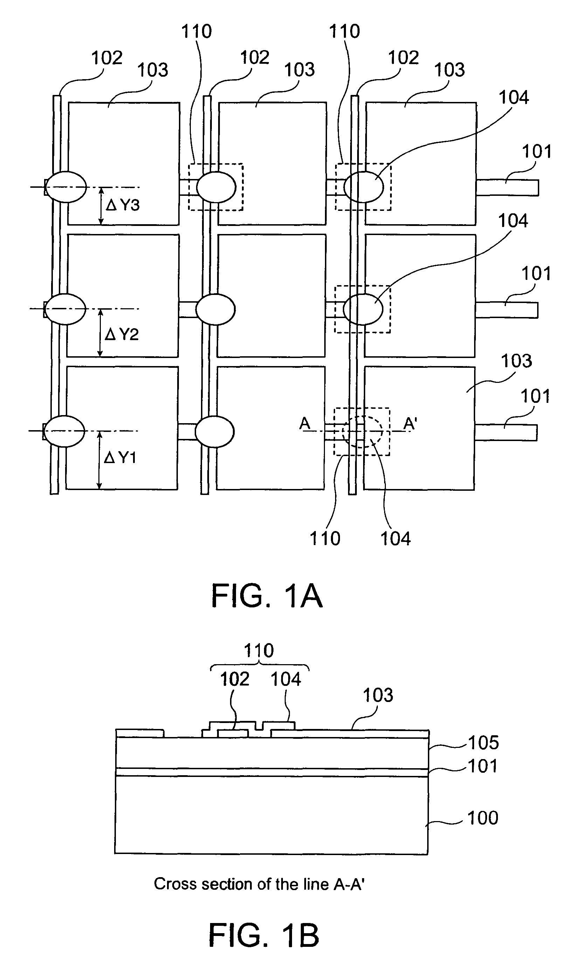

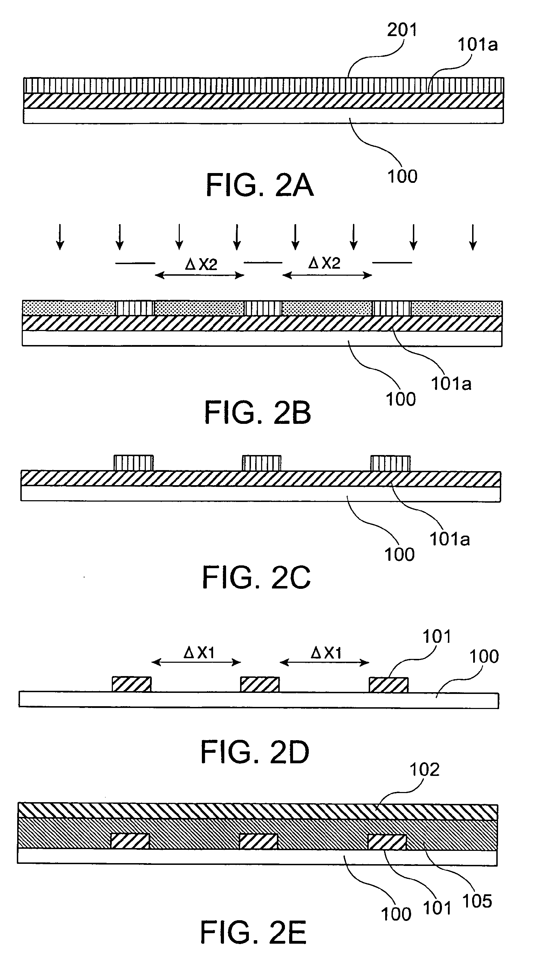

FIGs. 1A and 1B are diagrams showing an active matrix substrate of the invention, Fig. 1A is a plan view, and Fig. 1B is a longitudinal sectional view. Further, FIG. 2 is a circuit diagram of FIG. 1A. It should be noted that in the following description, a semiconductor film 102 direction in FIG. 1B is called "top side" and a base material 100 direction is called "bottom side."

The active matrix substrate of FIGs. 1A and 1B is such that first wirings 101 are formed on a base material 100 at an approximately regular interval. An insulating film 105 is formed thereon, and further thereon, second wirings 102 and pixel electrodes 103 are patterned.
Further, a semiconductor film 104 is formed such as to overlay a region, in which the first wiring 101 and the second wiring 102 intersect, and a region in which the first wiring 101 and the pixel electrode 103 intersect. Consequently, the semiconductor film 104 covers at least the second wiring 102, the pixel electrode 103, and the insulating film 105.

Moreover, in the display area consisting of a plurality of pixel electrodes 103, the first wirings 101 and the second wirings 102 form a band shape having a constant width, whereas there is no structure corresponding to a pitch of the pixel electrode in its longitudinal direction.
On the other hand, one side of the pixel electrode 103 is parallel to the second wiring 102 and the pixel electrodes103 are positioned at regular interval.

In this configuration, vicinities of the region, in which the first wiring 101, the second wiring 102, and the pixel electrode 103 intersect, operate as a transistor 110 and control voltage on the pixel electrode 103. Namely, applying a voltage on the first wiring 101 causes the transistor 110 to switch between the "on" state and the "off" state, so that a voltage signal set on the second wiring 102 changes the voltage on the pixel electrode 103 or is held. This makes it possible to control voltage on arbitrary pixel electrode 103 on the active matrix substrate.

The invention features that a relative position of the transistor 110 to the pixel electrode 103 is variable. Or, it may be said that this is based on a structure which permits changes in the relative position. For example, the distances ΔY1, ΔY2, and ΔY3 from a lower side of the pixel electrode 103 to the transistor 110 as shown in FIG. 1 are not necessarily the same (or constant).
Such changes in the relative position may occur, for example, through the expansion and contraction of the base material 100. When such expansion and contraction of the base material 100 occurs during the process of forming the first wirings 101, the second wirings 102, and the pixel electrodes 103, the relative positions (or distances ΔY1, ΔY2, and ΔY3) vary on the active matrix substrate.
Even in the case of using a glass base, such variation may occur due to thermal contraction. Further, this is even more significant on a plastic base. In the case of plastic bases, not only thermal contraction but also contractions due to the absorption of humidity and stress are considerable.

FIG. 2 shows how the wirings 101 are formed on the base material 100. In this process, several methods to be explained later may be used. As an example here, the formation of a conductive thin film, photolithography, and etching are used. Namely, after uniformly forming a thin film 101a of conductor on the base material 100 by means of vacuum evaporation, sputtering or the like, there follow photoresist coating, exposure using a photo mask and development. Then, the photoresist remaining on the thin film is used as a mask with which the conductor is etched, whereby a conductive thin film is patterned as shown in FIG. 2 may be obtained.

A space ΔX1 of the first wiring 101 (observed value for the sake of convenience) thus obtained is supposed to be identical to a space ΔX2 (theoretical value for the sake of convenience) of an original pattern drawn on the photo mask.
However, in actuality, as described above, the base material 100 expands or contracts due to temperature, humidity absoption, stress, heating history and the like, hence, strictly speaking, the observed value ΔX1 and the theoretical value ΔX2 are not the same,

Next, the insulating film 105 is formed on the base material 100 and the first wirings 101. The insulating film 105 may be obtained from a liquid material or a vapor phase. Details will be covered later. Typically, a solution of insulating polymeris spin-coated to obtain a uniform insulating film 105.
A polymer film can be made insoluble through a crosslinking reaction. Further, it is possible to form an SiO₂ insulating film 105 from a solution material by coating a solution such as polysilicate, polysiloxane, and polysilazane and annealing a coated film in the presence of oxygen or water vapor.

And, the second wirings 102 and the pixel electrodes 103 are formed on this insulating film 105. For this process, the same technique as the process of forming the first wirings 101 can be used. Namely, after uniformly forming a thin film of conductor on the insulating film 105 by means of vacuum evaporation, sputtering and the like, there follow photoresist coating, exposure using a photo mask and development. Then, the photoresist remaining on the thin film is used as a mask with which the conductor is etched, whereby the second wirings 102 and the pixel electrodes 103 (not illustrated) can be formed in a manner of intersecting the first wirings 101 indirectly with having the insulating film 105.

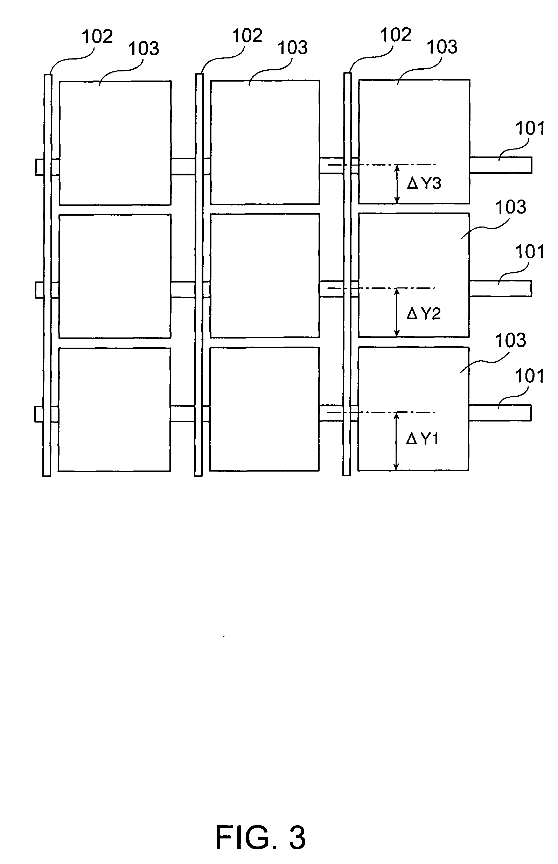

FIG. 3 shows the state of the intersections among data lines 102, the pixel electrodes 103 and scanning lines 101. Distances between the first wirings on the active matrix substrate and one side (bottom side) of the pixel electrodes 103 are shown as ΔY1, ΔY2, and ΔY3. A pixel pitch in the longitudinal direction of the second wiring is designed to be equal to the interval of the first wiring 101. Consequently, the distances ΔY1, ΔY2, and ΔY3 should be equal to each other in terms of design.
However, as described above, if the expansion and contraction of the base material 100 cannot be ignored, the pixel pitch of the pixel electrodes 103 in the longitudinal direction of the second wirings 102 is not necessarily the same as the interval of the first wirings 101, hence, the distances ΔY1, ΔY2, and ΔY3 could be different from each other.
FIG. 3 shows these differences exaggeratedly. In reality, when the areas near the both edge of the display areas are compared, such differences should be easily recognizable.

Subsequently, as shown in FIG. 1, semiconductor films 104 are formed thereon. In this case, it is possible to form the semiconductor film 104 uniformly (over the entire surface), but the fabricating of island structures only on limited areas is more preferable. Namely, semiconductor films are formed in a manner of covering the areas in which the second wiring 102 and the pixel electrode 103 intersect the first wiring 101.
As a method of patterning in this case, photolithography may be used, but a method using an inkjet process is the most desirable. This is because an inkjet process makes it possible to selectively deposit a material consisting of the semiconductor film 104 or a photoresist necessary for patterning the semiconductor film 104, in a manner of covering the area in which the second wiring 102 and the pixel electrode 103 intersect the first wiring 101.
According to the inkjet process, while an inkjet head scans over the base material 100, a liquid material is discharged from nozzles of a head of such as an inkjet apparatus. The interval of the inkjet nozzles can be freely varied by tilting a column of nozzles of the inkjet head with regard to the scanning direction and a jetting timing is also freely adjustable. Therefore, it is not difficult to form islands of the semiconductor film 104 in a manner of covering areas, in which the second wiring 102 and the pixel electrode 103 intersect the first wiring 101, over the entire surface of the display area.

As the semiconductor film 104, an organic semiconductor is the most desirable. It is the simplest method of forming the semiconductor film 104 to dissolve a soluble organic semiconductor in a solvent to obtain a solution, which may be coated with the inkjet head and dried. A precursor solution of the organic semiconductor may be coated and dried, which is converted to semiconductor by annealing to obtain the semiconductor film 104.

Otherwise after the semiconductor film 104 is first formed uniformly on the insulating film 105, the second wirings 102, and the pixel electrodes 103, an inkjet process is used to coat the resist in a manner of covering the areas in which the second wiring 102 and the pixel electrode 103 intersect the first wiring 101. Then the semiconductor film 104 is etched, and patterning can be carried out in such a way as to leave the semiconductor layer 104 on only the above-referenced areas.

At any rate, it is desirable to use an adaptive method to an existing pattern on the base material 100 like the inkjet process for patterning the semiconductor film 104. The reason is the following: A plastic substrate may be used for the base material 100 as a case in which the invention is especially effective. In such a case, the positions for forming the islands of the semiconductor film 104 may not be determined uniquely.
This is because, as described previously, the plastic substrate expands and contracts due to temperature, absorption of humidity, stress, heating history and the like, thus causing fluctuation in the position of the area, in which the second wiring 102 and the pixel electrode 103 intersect the first wiring 101.
In addition to the inkjet process, the use of a dispenser or patterning by scanning with a laser beam is effective as well.

As described above, the transistor 110 can be formed in this manner on each pixel electrode 103. It is possible to provide a pixel with a capacity line to increase a pixel capacity. This is formed concurrently with or parallel to the formation of the first wiring 100. The capacity lines, which are formed across each pixel electrode 103 and the insulating film 105, is able to increase a quantity of electric charges stored on the pixel electrode 103.

Each part making up the transistor 110 will now be described in more details.

The base material 100 supports each layer (each part) consisting of the transistor 110. For the base material 100, for example, there may be used materials such as a glass substrate, a plastic substrate (resin substrate), which is composed of , polyimide, polyethylene terephthalate (PET), polyethylene naphthalate (PEN), polymethylmethacrylate (PMMA), polycarbonate (PC) and the like, a quartz substrate, a silicon substrate, a gallium arsenic substrate and the like.
In case of providing flexibility to the transistor 110, a resin substrate is selected for the base material 100.

On this base material 100, an undercoat layer may be formed. For the undercoat layer, for example, it is formed as a gas barrier to shut off a gas passing the base material 100, for purposes of preventing ions from diffusing from the surface of the base material 100, or for improving close adhesion (bonding) between the first wiring 101 and the base material 100 and the like.

Regarding the material of the undercoat layer, there is no specific restriction. When using a glass substrate for the base material 100, silicon oxide (SiO₂), silicon nitride (SiN), a UV resin and the like are suitable for the layer.

The first wiring 101 operates as a gate electrode of the transistor 110, so that by means of a voltage applied thereon, it can control current flowing between the source and drain of the transistor 110.
The first wiring 101 consists of a material having electrical conductivity. For example, Pd. Pt, Au, W, Ta, Mo, Al, Cr, Ti, Cu or alloys containing these metals, conductive oxides such as ITO, FTO, ATO, and SnO₂, carbon materials such as carbon black, carbon nanotube, and fullerene, and conductive polymers including polythiophene, polyaniline, poly (p-phenylene), poly (p- phenylenevinylene), polyfluorene, polycarbazole, polysilane or their derivatives such as polyacetylene, polypyrrole, and PEDOT (polyethylenedioxythiophene).
And they are used in a conductive state in which they are doped with a dopant such as conventional iron chloride, iodine, strong acid, organic acid, and polystyrenesulphonic acid. Further, one kind or more than two kinds of these in combination can be used.

The width of the first wiring 101 determines the channel width of the transistor 110. Namely, other conditions being equal, the larger the width of the first wiring 101 becomes, the larger flow of current between the source and drain can be controlled, although the capacity of a gate input becomes large.
For the width of the first wiring 101, about 1 through 1000nm is appropriate, and 3 through 30 microns is very suitable. While a thickness (average) of the first wiring 101 is not particularly specified, about 0.1 through 2000nm is preferable. Even more preferable is approximately 1 through 1000nm.

The insulating film 105 is preferably mainly made of an organic material (especially organic high molecule materials). The insulating film 105 having a polymer as its main material lends itself easy to be formed, while, at the same time, in case an organic semiconductor is employed for the semiconductor film 104, it is possible to improve adhesiveness between the two.

For such polymers, there are cited, for example, acrylic resins such as polystyrene, polyimide, polyamidoimide, polyvinylphenilene, polycarbonate (PC), and polymethylmethacylate (PMMA), fluoride resins such as polytetrafluoroethylene (PTFE), phenol resins such as polyvinylphenol or novolac resins, and olefin resins such as polyethylene, polypropyrene, polyisobutylene, and polybutene. One kind or more than two kinds of these in combination can be used.

While a thickness (average) of the insulating film 105 is not particularly specified, about 10 through 5000nm is preferable. Even more preferable is approx. 100 through 1000nm. By making the thickness of the insulating film 105 fall within the above-referenced range, it is possible to adjust the current between the source and drain electrodes and the gate capacity with stablely insulating the second wiring 102 and the pixel electrode 103 from the first wiring 101.

It should be noted that as regards the insulating film 105, it is not limited to a single layer, and it may be a multi -layered structure..

Further, for materials constituting the insulating film 105, for example, inorganic insulating materials such as SiO₂ may be used. It is possible to obtain SiO₂ from a solution material by coating a solution such as polysilicate, polysiloxane, and polysilazane and annealing a coated film in the presence of oxygen or water vapor.
Further, after coating a metal alkoxyde solution, this is heated in oxygen atmosphere, then, it is possible to obtain an inorganic insulating material (known as a sol-gel process).

The second wiring 102 and the pixel electrode 103 are formed on the insulating film 105. The second wiring 102 and the pixel electrode 103 operate as the source and drain electrodes of the transistor 110, so that a current flows in the semiconductor films 104 here.

The second wiring 102 and the pixel electrode 103 are composed of conductive materials. If the pixel transistor 110 is a p-type field effect transistor, it is preferable for the second wiring 102 and the pixel electrode 103 to be metals having a high workfunction or a p-type doped semiconductor.
For conductive materials having relatively high workfunctions, there may be cited metallic materials such as Ni, Cu, Co, Au, Pd, Pt, and Ag. One kind or more than two kinds of these in combination may be used. Further, there may be cited conductive oxides such as ITO, FTO, ATO, and SnO₂, carbon materials such as carbon black, carbon nanotube, and fullerene, and conductive polymer materials including polythiophene, polyaniline, poly (p-phenylene), poly (p-phenylenevinylene), polyfluorene, polycarbazole, polysilane or their derivatives such as polyacetylene, polypyrrole, and PEDOT (poly-ethylenedioxythiphene). And they are used in a conductive state in which they are doped with dopant such as conventional iron chloride, iodine, strong acid, organic acid, and polystyrenesulphonic acid. Further, one kind or more than two kinds of these in combination can be used.

If the transistor 110 is an n-type field effect transistor, metals with a low workfunction are used, for example Al, Ti, Cr, Mg, Ca, rare earth metals and the like, or an n-doped semiconductor. This enables an electron injection barrier from the second wiring 102 to be decreased. It is also effective to have additional layers on the above-referenced metallic materials with fluorides or oxides which enhance injection of electrons such as LiF, AIF, and CsF.

The semiconductor film 104 is formed such as to come in contact with the second wiring 102 and the pixel electrode 103 as well as the insulating film 105. For the semiconductor materials, inorganic semiconductors such as amorphous Si, polycrystalline Si, and ZnO are effective. However, organic semiconductor materials are best suited in that the semiconductor film 104 can be formed on the plastic substrate even at low temperature.

As organic semiconductor materials, for example, small molecular organic semiconductor materials such as naphthalene, anthracene, tetracene, pentacene, hexacene, phthalocyanine, perylene, hydrazone, triphenylmethane, diphenylmethane, stilbene, arylvinyl, pirazorine, triphenylamine, triarylamine, phthalcyanine or their derivatives, and polymeric organic semiconductor materials such as poly-N-vinylcarbazol, polyvinylpyrene, polyvinylanthracene, polythiophene, plyhexylthiophene, poly (p-phenylenevinylene), polythinylenevinyl, plyarylamine, pyreneformalaldehyde resin, ethylcarbazolformalaldehyde resin, fluorene-bithiophene copolymer, fluorene-arylamine copolymer or their derivatives can be cited.
One kind or more than two kinds of these in combination can be used. Or an oligomer including thiophene, triphenylamine, naphthalene, perylene, and fluorine can be used.

### Second Embodiment

Next, a manufacturing method of an active matrix substrate of the invention will be described in detail.

The first wiring 101 is formed of the above-referenced materials on the base material 100 or on the undercoat layer formed on the base material 100. For this purpose, photolithography, selective plating or printing is used.
Photolithography involves a process using etching or a process using the lift-off. In the etching process, patterning is carried out by etching a uniformly formed conductive layer with a photoresist as a mask.
In the lift-off process, the first wiring 101 is formed by forming uniformly a conductor layer on the patterned photoresist and peeling and removing the conductor layer on the photoresist together with the photoresist.
For processes of uniformly forming the conductor layer, there are available processes of carrying out in vacuum such as vacuum evaporation, sputtering, and chemical vapor deposition, or processes of coating the liquid material by spin coating, dipping, doctor blade method and the like. Further, electrolytic plating as well as electroless plating may be used.
Selective plating is, in this context, a process, in electroless plating, of forming a plated layer only at a location where the first wiring 101 should be. Efficient manufacture is possible because of no need of etching. This is carried out by pattern a photoresist or a charging controlling agent and making a catalyst, which is necessary for starting electroless plating, adsorbed selectively on the base material 100.

For printing processes, screen printing, offset printing, inkjet printing and the like may be cited. Using a dispersing liquid of metallic particles, a solution/dispersing liquid of conductive polymers, or low-melting point metals as ink, and by coating, drying or solidifying ink only at conductive parts, it is possible to obtain desired patterns.

Next, the insulating film 105 is formed on the first wiring 101. This coated film can be obtained from the solution including an insulating material or its precursor is coated (supplied) onto the first wiring 101 or onto the base material 100, by means of the coating process and, optionally, by carrying out post-treatment (for example, heating, irradiation of an infrared ray, providing ultrasonic wave and the like).

Further, for the coating process, the same process as the above-referenced process may be used. If the first wiring 101 is a soluble organic semiconductor material, it is necessary to choose solvents which will not swell or dissolve the first wiring 101.

Further, instead of forming the insulating film 105 uniformly by the coating process, it is also effective to form the insulating film 105 by the printing process selectively on areas where it should be. Since it is necessary to insulate the first wiring 101 from the second wiring 102 and the pixel electrode 103, the insulating film 105 in the display area must at least cover the first wiring 101. It is effective to form the insulating film 105 by the printing process in a band form in a manner of covering the first wiring 101.

Further, a film-deposition processes in vacuum, which require expensive equipment compared to coating or printing processes, is also applicable. Vacuum evaporation, sputtering, chemical vapor deposition (CVD) and the like are cited for film-deposition processes in vacuum. Any of these processes introduces a solid or a gas serving as a raw material into a vacuum chamber, and by making it in a high temperature state through heating or plasma, a thin film is produced.
For example, a target of silicon dioxide or silicon nitride can be subjected to sputtering through argon plasma. Or instead of argon gas, oxygen or nitrogen gas is introduced and with its plasma, it is possible to obtain silicon oxide or silicon nitride.
Furthermore, it is possible to obtain a dielectrics by introducing a silane gas, oxygen gas, amnonia gas and the like and by causing these to react in heat or plasma.
Because these processes are able to produce high quality thin films, they can be used for manufacturing high quality elements.

Next, the second wiring 102 and the pixel electrode 103 are patterned. The second wiring 102 and the pixel electrode 103 are formed on the insulating film 105. In the case of that the insulating film 105 is patterned, base material 100the second wiring 102 and the pixel electrode 103 are formed also on the base material 100 or an undercoat layer formed on the base material 100. For forming the second wiring 102 and the pixel electrode 103, the same process as the above-referenced first wiring 101 can be used.
Techniques using masks or printing plates can be well applied, since the invention is tolerant of the expansion and contraction of a substrate or a mask for fabricating transistor structures. For example, it is possible to obtain the second wiring 102 and the pixel electrode 103 through patterning a sputtered metallic layer by using etching or the lift-off based on photolithography.
Further, it is possible to conduct exposure using a quartz mask for pre-patterning to carry out selective electroless plating. Furthermore, a conductor can be printed by using screen printing.

As the last step in the process of forming the transistor 110, the semiconductor film 104 is formed. For this purpose, it is possible to use the coating process, the printing process, a vacuum film-deposition process and the like. As shown in FIG. 1, patterned the semiconductor film 104 for each transistor 110 is the most desirable. In this case, interference between a plurality of transistors 110 can be minimized.
In this case, if the printing process is used, the formation of thin films and patterning can be simultaneously carried out. It is necessary, in this case, to form the semiconductor film 104 in alignment with the electrodes of the transistor 110. Namely, the semiconductor film 104 must be formed on the area in which the first wiring 101 intersects the second wiring 102 and the pixel electrode 103.
The inkjet printing process can cope with such a request most adequately. Since the inkjet printing process is non-contact printing, alignment can be properly carried out. Further, when forming the semiconductor film 104 by using the inkjet head having a plurality of nozzles, to match a interval of the nozzles to a interval of the transistor 110, it is effective to rotate the inkjet with respect to a relative scanning direction of the inkjet and the substrate. This rotation allows the nozzles to adapt with the interval of the transistor 110 freely, so that it is the most suitable manufacturing method for the devices that are fabricated by the invention that has a great tolerance in the expansion and contraction of the substrate.

Now, the first intersection in which the first wiring 101 intersects the second wiring 102 or the second intersection in which the first wiring 101 intersects the pixel electrode 103 is optically detected as an alignment mark, whereby alignment and the above-referenced rotation of the inkjet head are carried out. For an optical detection process, the simplest process is a process of obtaining a two-dimensional image of an object through an element which combines a two-dimensional optical detecting element such as a CCD and a lens, whereby image processing detection is carried out by a computer.

In printing processes other than the inkjet printing process, the printing plate and the like need to be in contact with the device, so that the device may get damaged or alignment may be difficult, but this is technically feasible. For example, in case of using screen printing, detection in advance of relative positions of the element and the screen for screen printing through the optical detection process enables alignment to be made.

By using the coating process and the vacuum film-deposition process, a uniform semiconductor film 104 ,which is not patterned, can be easily obtained. If the semiconductor film 104 is an intrinsic semiconductor with sufficiently high electric resistance, the interference between devices is relatively small, therefore it is feasible to use non-patterned semiconductor film 104.
However, a distance between adjacent pixels must be widened so as to increase a channel length of a transistor that is formed in a space with the adjacent wiring 102. Consequently, this poses a problem of decreasing an aperture ratio.

Further, after the semiconductor film 104 is uniformly formed, it can be patterned in combination with printing processes. A material ,which functions as a photoresist, is patterned, and by using it, it is possible to apply etching to the semiconductor film 104 to carry out patterning it.

### Third Embodiment

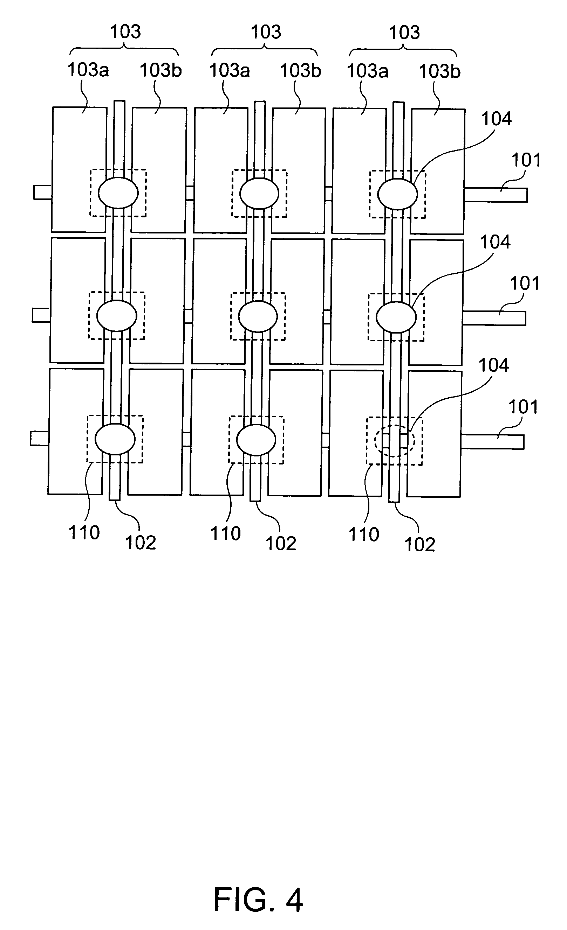

As a derivative example of the active matrix substrate of FIG. 1, a structure shown in FIG. 4 is possible. In this structure, the pixel electrode 103 is divided into 103a and 103b and separated by the second wiring 102. The semiconductor film 104 is formed such as to overlay the pixel electrodes 103a, 103b, and the second wiring 102. In this case, the pixel electrodes 103a and 103b divided as the pixel of a display unit operate as one pixel electrode.
In the configuration of FIG. 1, when forming the semiconductor film 104, it is not desirable for the semiconductor film 104 to be formed in such a way as to link the adjacent pixel electrodes 103. This is because interference between pixels would occur, so that there would be no meaning of patterning the semiconductor film 104.
As a result, when patterning the semiconductor film 104, it is necessary to ensure that the semiconductor film 104 would not extend to the adjacent pixel electrodes. However, in the case of a plastic substrate , which has large expansion and contraction, precise alignment is not necessarily achievable, thus leading to a possibility of the semiconductor film 104 overlaying between the adjacent pixel electrodes.
To avoid such difficulty, the semiconductor film 104 is provided at a location close to a center of the pixel. Namely, the configuration of FIG. 4 is effective. Even if there is a slight misalignment of the position of the semiconductor film 104 or a fluctuation of its size, there is no possibility of linkage made among a plurality of pixels.

### Fourth Embodiment

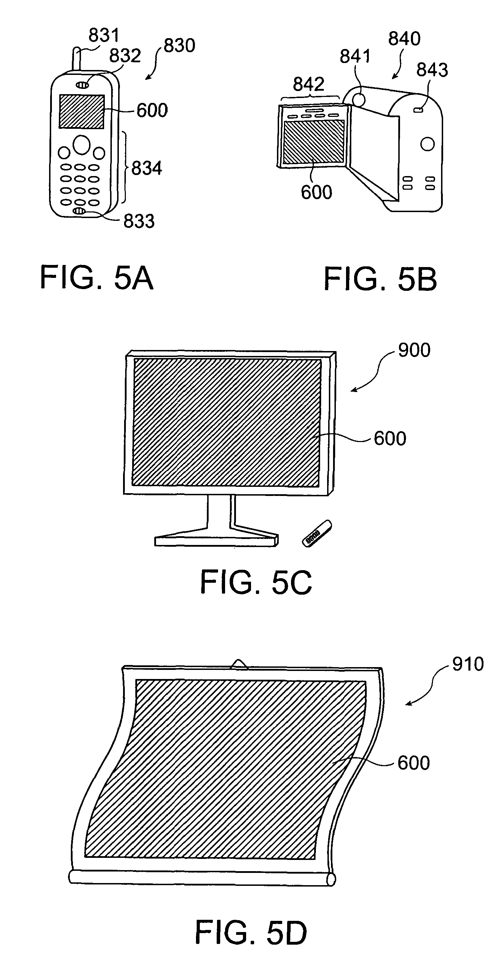

The above-referenced active matrix substrate may be suitably used in an electro-optical device equipped with an electro-optical element. Further, it may be suitably used in an electronic apparatus equipped with an electro-optical device. FIG. 5 is a diagram showing examples of various electronic apparatuses constituted by including an electro-optical device 600.

FIG. 5A is an example of application to a mobile phone. The mobile phone 830 is constituted by an antenna section 831, a voice output section 832, a voice input section 833, an operating section 834, and an electro-optical device 600 of the invention.
FIG. 5B is an example of application to a video camera. The video camera 840 is constituted by an image receiving section 841, an operating section 842, a voice input section 843, and an electro-optical device 600. FIG. 5C is an example of application to television, and the television 900 is equipped with the electro-optical device 600.
It should be noted that the electro-optical device 600 may be applicable likewise to a monitor unit used in personal computers and the like. FIG. 5D is an example of application to a roll-up television, and the roll-up television 910 is equipped with the electro-optical device 600.

It should be noted that as the electronic apparatus, it is not limited to this. The electro-optical device 600 can be applied to all kinds of electronic apparatuses such as a fax machine with a display function, a digital camera finder, a portable TV, an electronic notebook, an electric bulletin board, display for advertising and promotion, an IC card, and a PDA. Working Example 1
On a polyimide substrate, 120 micron thick, 1 nm of Cr and 100 nm of Au were deposited by sputtering. On this, a photoresist was coated, and after exposure by using the first wiring 101 and a photo mask having a pattern corresponding to an electrode for externally wiring the first wiring 101, there followed development and drying. Then an Au layer and a Cr layer were subjected to etching.
A width of the first wiring 101 was made to be 20 microns. Subsequently, a 7% butyl acetic acid solution of poly- methylmethacrylate (PMMA) was uniformly coated by spin coat to form an insulating film 105 of a thickness of approx. 1 micron. Then, 1 nm of Cr and 100 nm of Au were deposited thereon by sputtering. On this, a photoresist was coated, and after exposure by using the second wiring 101, the pixel electrode 103, and a photo mask having a pattern corresponding to an electrode for externally wiring the second wiring 101, there followed development and drying. Then the Au layer and the Cr layer were subjected to etching.
For a size of a space between the second wiring 102 and the pixel electrode 103, 3 microns were obtained. The pixel electrode was at a cycle of 150 microns. Resolution as a display unit was approx. 170 pixels per inch. Then, finally, a 1% solution of cyclohexylbenzene of polyfluorenebithiophen was dripped by using the inkjet head to the area in which the first wiring 101 intersect the second wiring 102 and the pixel electrode 103, and drying was carried out at 80°C, whereby the semiconductor film 104 was obtained.

For the substrate, a size of 200mm x 300 mm was used, and care was exercised to assure a temperature range of ±15 degrees at the time of burning. Then, although a change occurred in the relative position inside the pixel of the transistor 110, one transistor 110 per pixel electrode was successfully formed. This operated in good condition as the transistor of a size of channel length 5 microns and channel width 20 microns.

When this circuit substrate was glued to an associated substrate (having a PET film as a substrate) with microcapsules including electrophoretic molecules coated on a counter electrode (ITO-made), it was confirmed that active matrix drive of electrophoretic elements was operable. Working Example 2
Manufacturing methods of the base material 100, the first wiring 101, the insulating film 105, the second wiring film 102, and the pixel electrode 103 were carried out in the same way as Working Example 1. Note, however, that the width of the first wiring 101 was set at 10 microns and a length of the space between the second wiring 102 and the pixel electrode 103 was set at 10 microns.
Next, pentacene was uniformly formed by sputtering over the entire surface of the display area in a thickness of 50 nm. Since it was considered that interference among pixels would be great as was, patterning was applied to form the semiconductor film 104. A 2.5% aqueous solution of polyvinyl alcohol was coated over the transistor 110 area, and pentacene was dry-etched by oxygen plasma, while polyvinyl alcohol was left as was.

When this circuit substrate was glued to the associated substrate (having a PET film as a substrate) with microcapsules including electrophoretic molecules coated on the associated electrode (ITO-made), it was confirmed that the active matrix drive of electrophoretic elements was operable.

The invention is not limited to the above-referenced embodiments, but a variety of modifications are possible.
For example, while the invention has been described in terms of bottom gate structure having a gate electrode on the substrate side, the spirit of the invention is that the invention can be carried out even in terms of top gate structure having the gate electrode on a side far from the substrate.
Further, the invention includes virtually the same construction (for example, the same construction of function, method, and effect or the same construction of purpose and effect) as the construction described in the embodiments. Still further, the invention includes a construction which replaced nonessential portions of the construction described in the embodiments.
Furthermore, the invention includes a construction which brings about the same operation/working-effect or the construction which can accomplish the same purpose as the construction described in the embodiments.

## Claims

1. An active matrix substrate, comprising:
a plurality of scanning lines above a base material;
a plurality of data lines intersecting the plurality of scanning lines;
an insulating film formed between the plurality of scanning lines and the plurality of data lines;
a plurality of pixel electrode overlapping the plurality of the scanning lines; and
a plurality of semiconductor films, each of the semiconductor films overlapping a part of one of the scanning lines, a part of one of the data lines, and at least a part of one of the pixel electrodes.

2. An active matrix substrate, comprising:
a first line above a base material;
a second line intersecting the first line;
an insulating film formed between the first line and the second line;
a first pixel electrode overlapping a part of the first line; and
a semiconductor film overlapping a part of the first line.

3. The active matrix substrate according to claim 2, the first line being a scanning line, and the second line being a data line.

4. The active matrix substrate according to claim 2, the semiconductor film overlapping a part of the first pixel electrode.

5. The active matrix substrate according to claim 2, the semiconductor film overlapping a part of the second line.

6. The active matrix substrate according to claim 2, further comprising:
a second pixel electrode overlapping a part of the first line, the semiconductor film overlapping a part of the first pixel electrode and a part of the second pixel electrode.

7. The active matrix substrate according to claim 2, further comprising:
a third line intersecting the second line, the insulating film being formed between the second line and the third line;
a third pixel electrode overlapping a part of the third line,
wherein an first overlapping area and an second overlapping area is different, the first overlapping area being formed between the first pixel electrode and the first line, and the second overlapping area being formed between the third pixel electrode and the third line.

8. The active matrix substrate according to claim 2, further comprising:
a third line intersecting the second line, the insulating film being formed between the second line and the third line;
a third pixel electrode overlapping a part of the third line,
wherein the third pixel electrode is divided into two areas by the third line and the first pixel electrode is divided into two areas by the first line, a first area ratio of the two areas of the first pixel electrode being different from a second area ratio of the two areas of the third pixel electrode.

9. The active matrix substrate according to claim 2, the semiconductor film being an island film corresponding to an intersection of the first line and the second line.

10. The active matrix substrate according to claim 2, the second line and the first pixel electrode consisting of a same material.

11. The active matrix substrate according to claim 2, the base material including a flexible material.

12. An electro-optical device having the active matrix substrate according to claim 2.

13. An electronic apparatus having the electro-optical device according to claim 12.

14. A method of manufacturing an active matrix substrate, comprising:
forming a first line above a base material;
forming an insulating film above the first line;
forming a second line and a pixel electrode above the insulating film so as to overlap a part of the first line; and
forming a semiconductor film above a part of the firs line, a part of the second line, and a part of the pixel electrode.

15. The method of manufacturing an active matrix substrate according to claim 14, the forming of the semiconductor film including applying a liquid material to form an island film on the part of the second line and the part of the pixel electrode, the island film being the semiconductor film.

16. The method of manufacturing an active matrix substrate according to claim 15, the applying of the liquid material being discharging the liquid material from a nozzle of a head.

17. A method of manufacturing an active matrix substrate, comprising:
applying a liquid material to a portion above a first line, the portion connecting a part of a second line and a part of a pixel electrode, the first line intersecting the second line and the pixel electrode, the first line and the second line being separated by an insulating film.

18. The method of manufacturing an active matrix substrate according to claim 15, the applying of the liquid material being discharging the liquid material from a nozzle of a head.

19. A method of manufacturing an electro-optical device using the method of manufacturing an active matrix substrate according to claim 17.

20. A method of manufacturing an electronic apparatus using the method of manufacturing an electro-optical device according to claim 19.
